Europäisches Patentamt

European Patent Office

Office européen des brevets

(11) Publication number : **0 588 492 A1**

## (12) EUROPEAN PATENT APPLICATION

(21) Application number : **93306421.4**

(22) Date of filing : **13.08.93**

(51) Int. Cl.5 : **G03F 7/004, G03F 7/023**

(30) Priority : **28.08.92 US 937913**

(43) Date of publication of application :
**23.03.94 Bulletin 94/12**

(84) Designated Contracting States :
**AT BE DE FR GB IT NL**

(71) Applicant : **MORTON INTERNATIONAL, INC.**
Morton International Building 100 North
Riverside Plaza Randolph Street at the River
Chicago Illinois 60606-1596 (US)

(72) Inventor : **Dixit, Sunit S.**
23572 Via Breve
Mission Viejo, California 92621 (US)

(74) Representative : **Bankes, Stephen Charles
Digby et al**
BARON & WARREN 18 South End Kensington
London W8 5BU (GB)

(54) High aspect ratio, flexible thick film positive photoresist.

(57) A crack-resistant thick film positive photoresist having a thickness of from greater than $5\mu$ to $100\mu$ is coated as a single layer on a substrate to provide a relief structure thereon having vias in which the sidewalls are substantially vertical. The photoresist composition comprises a novolac resin, a photosensitizer, and a copolymer of an alkyl vinyl ether and an unsaturated dicarboxylic acid, ester or anhydride thereof.

EP 0 588 492 A1

FIELD OF THE INVENTION

This invention relates to a positive working photoresist having a superior photospeed and a high contrast capability. It relates particularly to a composition which is capable of forming a single layer, 100μ thick resist. More particularly, it relates to a flexible thick film resist having several uses, the bonding of semiconductor chips in the manufacture of multi-chip modules being one of the more notable ones.

BACKGROUND OF THE INVENTION

Layers of positive working photoresists up to about 100μ thick and the resultant high aspect ratios are of increasing interest for a multitude of applications. For example, the electric conductance of magnetic head interconnection circuitry fabricated by the photoresist technique is increased by the increased thickness of the copper or other conductor which is plated on the substrate according to patterns outlined in the photoimaged and developed thick film resist.

With the expectation that the market for multi-chip modules (MCM) will grow into a billion dollar business in the packaging of integrated circuits, the focus of more and more research is on interconnect techniques. MCM packaging is attractive to the IC industry in part because the close grouping of the die affords shorter pathways between chips and the consequent shorter time for the passage of electrical signals. Among the three technologies in current use for joining chips, the solder bump (C4) flip chip process is uniquely suited to the requirements of high density VLSI chips, i.e., 500-1000 I/O's per chip. The solder bump process requires a photoresist that can be coated on a substrate in one application to a thickness of from 50 to 60μ. The film must have a uniform thickness and the sidewalls of the vias in the relief images developed therein must be substantially vertical. Currently, the typical thick film resists exhibit very poor thickness uniformity and are susceptible to outgassing and cracking when the thickness is greater than about 5μ. Also, until this invention a 100μ thick coat of the known resists could not be achieved in a single coating step. The pumping, coating, baking, exposing, and developing of the thick film resist candidate for the solder bump process must fit the standard semiconductor process and be compatible with the equipment. No resist currently on the market meets all of the requirements of the solder bump process.

If the solder bump flip chip process is used as the interconnect technique in MCM manufacturing, conventional photosensitive polyimides must be used as the dielectric material to be patterned for use as interlayers in MCM's. High thermal resistance is required. However, if one of the other chip joining techniques, i.e., wire bonding or tape automated bonding, is used the photoresist required for patterning the dielectric for MCM manufacturing may be based on novolac resins. It must have the same properties as those required for the solder bump process but the film thickness need only be from about 7 to about 25μ.

The coating properties of a photoresist comprising a novolac resin, a quinone diazide photosensitizer, and a propylene glycol alkylether acetate are improved by the addition of a plasticizer such as polypropylene acetal resin according to U. S. Patent 5,066,561. A smooth film of uniform thickness is said to result. Nevertheless, it has been found that the addition of up to 3% by weight of Formvar 5/95 E acetal resin (Monsanto) to a mixture of a novolac resin, a quinone diazide photosensitizer, ethyl lactate and butyl acetate gave none of the properties discussed earlier as necessary properties of a thick film resist. Segregation of discrete resin particles was observed. A substituted hydroxy phenyl benzotriazole at concentrations up to 2 weight percent and t-butylphenol at up to 1% by weight were not effective for the purposes of this invention.

SUMMARY OF THE INVENTION

It is an object of this invention, therefore, to provide a positive photoresist composition capable of forming a uniformly thick, flexible, crack-resistant coating of up to 100μ thickness on a substrate.

It is another object of this invention to provide a radiation sensitive recording material having a uniformly thick single layer of a flexible, fast, tightly adhering positive working photoresist having a thickness of up to about 100μ.

It is a related object to provide a method for applying such a coating as a single layer.

It is a further object to provide a thick film positive photoresist which is not subject is outgassing following its application to a substrate and evaporation of solvents therein.

It is another object of this invention to provide a one-ply thick film positive working photoresist which yields substantially vertical sidewalls for the vias in relief images generated by exposure of the resist to patterned actinic light and dissolution of the exposed pattern.

It is another object of this invention to provide a substrate having a relief structure thereon which comprises substantially vertical vias extending completely through a single layer of a positive photoresist up to 100μ thick

and having a high aspect ratio.

It is still another object of this invention to provide a thick film photoresist which will withstand the corrosive effects of a gold plating solution.

These and other objects which will become apparent from the drawings and the following description of the invention are achieved by depositing on a suitable substrate a single layer of a positive photoresist composition comprising a novolac resin, a photosensitizer, a copolymer of an alkyl vinyl ether and an anhydride-forming unsaturated dicarboxylic acid, and a solvent in an amount sufficient to form a film having a dry thickness of from greater than $5\mu$ to about $100\mu$, drying the layer, exposing the film imagewise to actinic radiation, baking the exposed film, and developing it.

## BRIEF DESCRIPTION OF THE DRAWINGS

Figure 1 is a graph showing the thickness of a photoresist of this invention formed at various spin coating speeds.

Figure 2 is a scanning electron micrograph of a vertical section of a $50\mu$ thick relief structure made according to the procedure in Example 1 hereinbelow.

Figure 3 is an SEM of a vertical section of a $100\mu$ thick relief structure made according to the prior art.

## DETAILED DESCRIPTION OF THE INVENTION

The preparation of novolac resins is well known in the art. Phenol and/or alkyl phenols are condensed with formaldehyde at temperatures of from 100 to 190°C for several hours in the presence of a acidic catalyst such as hydrochloric acid, oxalic acid, zinc acetate, or magnesium acetate and the reaction mixture is then stripped of water and unreacted formaldehyde to give a novolac resin. A procedure for their preparation is given in Chapter 4 of <u>Chemistry and Application of Phenolic Resins,</u> Knop and Scheib; Springer Verlag, New York, 1979. See also "Plastics Materials 15, Phenolic Resins", published Jan. 20, 1978 by Nikkan Kogyo Shinbunsha, pp 141-142. Novolacs made from 100% p-cresol are suitable, as are $50/50_{wt}$ mixtures of novolacs made from 65% p-cresol/35% m-cresol and 55% p-cresol/45% m-cresol.

Also, the use of o-quinone diazides as photosensitizers is well known to those of ordinary skill in the photoresist art and it is described at Chapter 7.4 of <u>Light Sensitive Systems,</u> Kosar; John Wiley & Sons, New York, 1965. Useful photosensitizers include the product of the condensation of 2-diazo-1-naphthoquinone-4-sulfonyl chloride (2,1,4 DNQ) or its structural homolog, 2,1,5 DNQ, with an oligomer of p-cresol and formaldehyde. For the purposes of this invention, the 2,1,5 DNQ condensate is preferred. These and others are disclosed in the patent literature, including U.S. Patent Nos. 2,797,213; 3,106,465; 3,148,983; 3,130,047; 3,201329; 3,785,825; and 3,802,885, all of which are hereby incorporated by reference.

The copolymerization of equal molar amounts of an alkyl vinyl ether, wherein the alkyl group is a lower alkyl group, with an anhydride-forming unsaturated dicarboxylic acid, a mono- or di-lower alkyl ester thereof or, indeed, the anhydride, provides a plasticizer which solves the problems of outgassing, cracking, and thickness uniformity when added to the mixture of novolac resin and photosensitizer. The adhesion of the resist to the substrate is improved yet development of the exposed resist renders vias free of resist adhering to the substrate at their bottom. It can be seen, therefore, that the plasticizer is the critical component of the resist which makes the method of this invention possible.

The terms "lower alkyl" and "lower alkyl group" are used herein to mean an alkyl group having from 1 to 4 carbon atoms. The alkyl group is exemplified by methyl, ethyl, propyl, and butyl, and it may be a branched chain as well as straight. The monomeric ethers are commercially available from suppliers such as the GAF/ISP Corporation. Maleic acid is the prime example of the unsaturated acid moiety of the copolymer, which is preferably made by hydrolysis of the copolymer of the unsaturated ether and anhydride. Fumaric acid and the itaconic and citraconic homologs of maleic acid, their anhydrides and esters, all of which are commercially available, are also suitable as co-monomers in this invention. Voss and Dickhauser describe methods for the copolymerization of vinyl ethers and unsaturated dicarboxylic acids, esters and anhydrides in U. S Patent No. 2,047,398. Verburg describes the free-radical copolymerization of methyl vinyl ether and maleic anhydride in U. S. Patent No. 2,782,182. The molecular weight of the copolymer for the purposes of this invention is from about 20,000 to about 80,000. The hydrolysed copolymer of methyl vinyl ether and maleic anhydride is preferred. It is offered by GAF/ISP under its trademark Gantrez® and a 1 $%_{wt}$ aqueous solution has a specific viscosity of from 1.0 to 10.0.

The copolymer may be from about 0.5 to about 4 percent by weight of the total weight of the photoresist composition but the amount is preferably from about 1 to 3 weight percent, 3% being the more preferred.

Ethyl lactate, n-butyl acetate and mixtures thereof are the preferred solvents for the photoresist compo-

EP 0 588 492 A1

sition of this invention. It is particularly preferred that the weight ratio of ethyl lactate and n-butyl acetate in mixtures of those solvents be about 85:15, although ratios of 95:5 and 75:25 are suitable. Other solvents that may be useful include ethyl cellosove acetate, propylene glycol mono-methyl ether acetate, ethylene glycol monomethyl ether acetate, xylene, and mixtures thereof. The total amount of solvent may be from about 30 to about 80% by weight of the total solution but it is preferably from about 40 to about 60 weight percent.

A preferred formulation of the photoresist composition comprises from about 30 to about 50 % of a novolac resin having a molecular weight of from about 5000 to about 10,000, from about 5 to about 10 % of a photosensitizer, from about 1 to about 4 % of a hydrolyzed copolymer of an alkyl vinyl ether and maleic anhydride, from about 35 to about 50 % of ethyl lactate, and from about 5 to about 10 % of n-butyl acetate, all percentages being by weight of the total composition. In a particularly preferred composition, the photosensitizer is the 2,1,5 DNQ ester of an oligomer of a p-cresol/formaldehyde condensate and the copolymer has a low molecular weight, on the order of about 20,000.

The photospeed of a 50% solution of the thick resist composition containing the above-given sensitizer is from about 200 to about 1800 mJ/cm$^2$.

The following specific examples provide detailed information about the method and products of this invention. It will be understood, however, that these examples are not a limitation on the scope of the invention in any way and should not be construed to provide conditions or values which must be used in the practice of this invention. In these examples, the percentages are by weight.

EXAMPLE 1

A solution having a composition as follows:

```
Novolac resin (HRJ4382)*        39.20
Photo sensitizer **              7.84
Ethyl lactate                   42.53
n-Butyl acetate                  7.50
Hydrolyzed methyl vinyl
ether/maleic anhydride
copolymer†                       2.91
     * Schenectady Chemical; mol.wt: 8400
     ** 215 DNQ/(p-cresol/formaldehyde)
     † Gantrez S-97
```

was prepared by mixing the novolac resin and the sensitizer with the solvent mixture with moderate agitation at ambient temperature for about 8 hours before the copolymer was added, whereupon the mixture was stirred for another 6 to 8 hours or until the copolymer was fully dissolved. The solution was filtered through a filter plate having 10μ pores. The viscosity of the resulting solution containing 50 % solids was 2698 cps, as measured by the Canon Fenske viscometer.

EXAMPLE 2

The general procedure of Example 1 is repeated except that the amount of solvent was adjusted to give a solution containing 45 % solids. The resulting composition had a viscosity of 654 cps.

EXAMPLES 3 & 4

In like manner, the viscosity decreased to 304 and then to 93 cps. as the percent solids of the solution was reduced to 40% in Example 3 and to 35% in Example 4.

The substrate for the recording material of this invention may be a wafer of silicon, aluminum, silicon dioxide, copper, tantalum, polysilicon, silicon nitride, or another ceramic. Coating of the wafer may be accomplished by the conventional dipping and spraying methods but spin coating is preferred because of its adapt-

4

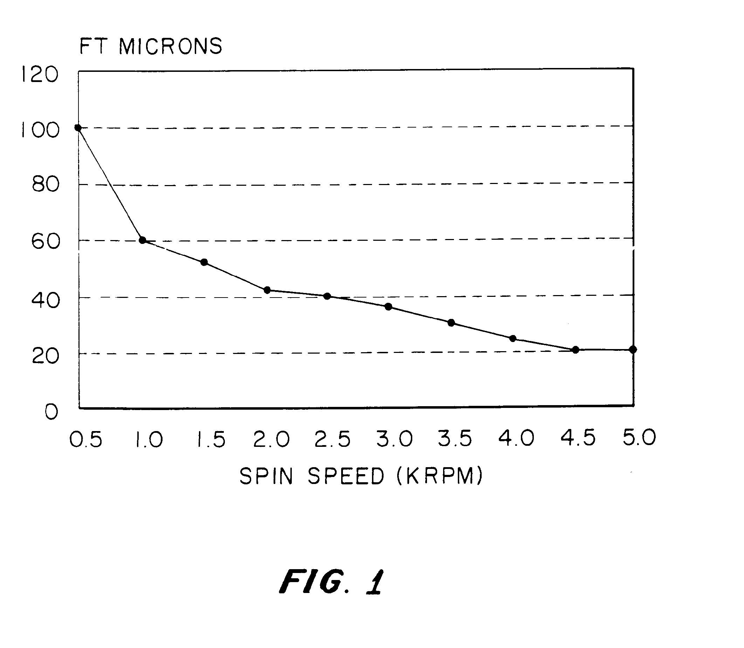

ability to calibration with respect to the viscosity of the photoresist solution, its solids content, the spin speed, the spinning time, and the desired coating thickness. This characteristic of spin coating makes it of particular importance to this invention because the full thickness of the coating is applied in one layer. In Fig. 1, the spin speed (in terms of thousands of revolutions per minute) is plotted against the film thickness (FT) of the photoresist of Example 1 when it is spin coated onto a 4" wafer of silicon and soft baked on a hot plate in three steps at 60°C/120 sec.; 80°C/90sec.; and 90°C/90sec.

The data in Table I show the effects of the copolymer level and of the ratio of ethyl lactate and n-butyl acetate on the thickness of the film when a 45 % solids solution of the novolac, photosensitizer, and copolymer of Example 1 is spin coated on a 4" silicon wafer and soft baked on a hot plate at 60°C/120 sec. and then at 90°C/30 minutes in a convection oven. The weight percent of the copolymer and the solvents ratio are given in Table I.

**TABLE I**

| Example | % copolymer | Ratio | Thickness ($\mu$) |
|---------|-------------|-------|-------------------|
| 5 | 3.0 | 95/5 | 23.2 |
| 6 | 3.0 | 75/25 | 16.4 |
| 7 | 3.0 | 85/15 | 18.3 |
| 8 | 2.0 | 95/5 | 24.8 |
| 9 | 2.0 | 75/25 | 20.4 |
| 10 | 2.0 | 85/15 | 20.6 |
| 11 | 1.0 | 95/5 | 27.1 |
| 12 | 1.0 | 75/25 | 26.3 |
| 13 | 1.0 | 85/15 | 23.8 |

After the substrate is coated with the solution of the resist, the solvents are evaporated by a soft bake procedure using a convection oven, a contact hot plate technique, a proximity hotplate technique, or a combination thereof. The temperature of the bake and the time are controlled so as to avoid substantial degradation of the resist, particularly the photosensitizer. Preferred conditions are baking of the coated substrate in a convection oven at 110°C for 15 minutes obviates outgassing.

EXAMPLE 14

A photoresist composition made according to the general procedure of Example 1 was spin coated onto two silicon wafers and soft baked at 60°C/120 secs., 80°C/90 secs., and 90°C/90 secs. to give nominal thicknesses of 100$\mu$. The uniformity of thickness was measured with a Leica film thickness device using a reflection wavelength of 780nm. Eight out of ten measurements of the first wafer read 99.15316$\mu$; the other two being 96.74816 and 97.95302. The minimum thickness among ten measurements of the second wafer was 100.58940$\mu$; the maximum thickness was 104.92665$\mu$; and the mean thickness was 102.29498$\mu$.

The coated substrate is then exposed to actinic radiation of any desired wavelength, suitably from 380 to 430 nm, in any desired pattern as produced by the use of suitable masks, negatives, stencils, templates and the like. The line width or critical dimension of the vias may be from about 10 to about 80$\mu$; it is preferably from about 20 to about 50$\mu$. The aspect ratio may be from 1 to about 10. The gap between the light source and the surface of the photoresist is suitably from 0 to about 60$\mu$. At a gap of from 20 to 60 microns, the sidewall angle of the via is within the range of 81 to 83°. The so-called soft contact exposure gives a sidewall angle of 82.0°.

After exposure, the resist coated substrate is developed in an aqueous alkaline solution. An alkali metal hydroxide, an ammonium hydroxide and a tetramethylammonium hydroxide exemplify the bases which may be used in solution as the developer. AZ 400K is a trademark for a solution of potassium hydroxide and boric acid sold by Hoechst. It may be used at a 3:1 or a 4:1 dilution ratio. Immersion, spraying and a combination spray/puddle method may be used. After development, the sidewalls of the vias are substantially vertical, which for the purposes of this invention means that the sidewall angles are from about 80° to 90°. As mentioned above, one of the advantages of this invention is that the substrate at the bottom of the developed vias is clean and free of residual photoresist.

## EXAMPLE 15

A 4" wafer of silicon was spin coated with a photoresist made according to the general procedure of Example 2 and soft baked at 60°C/120 secs., 80°C/90 secs., and 90°C/90 secs. to give a single layer 30μ thick, then photoimaged with patterned light and developed to give vias for bump plating. It withstood the corrosive effects of a gold plating solution.

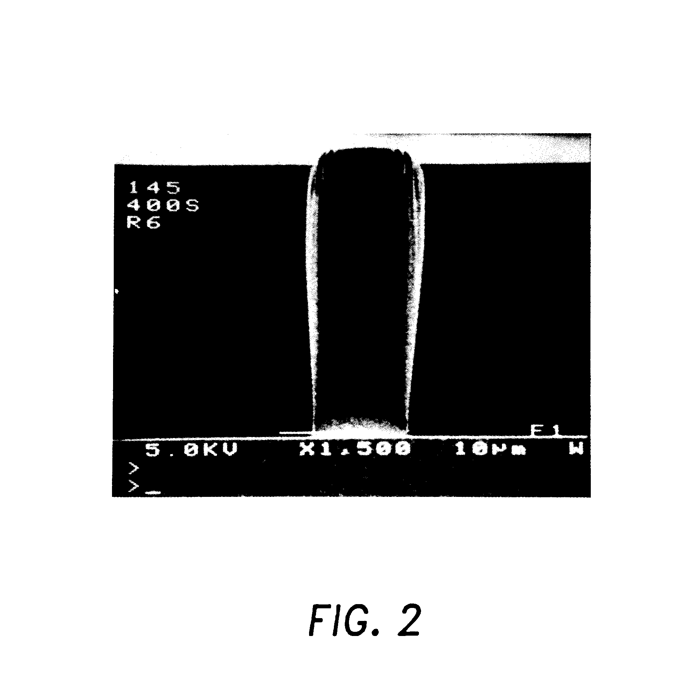

In Fig. 2, the SEM is of a 50μ thick single layer of a photoresist made according to the general procedure of Example 2 on a 4" silicon wafer. Soft bake: hot plate 60°C/120 sec.; convection oven 90°C/60 min. Exposure: Canon PLA 501FA, 1.56 J/cm$^2$, soft contact. CD: 5 μ. Development: AZ 400K spray - 2.5 min.

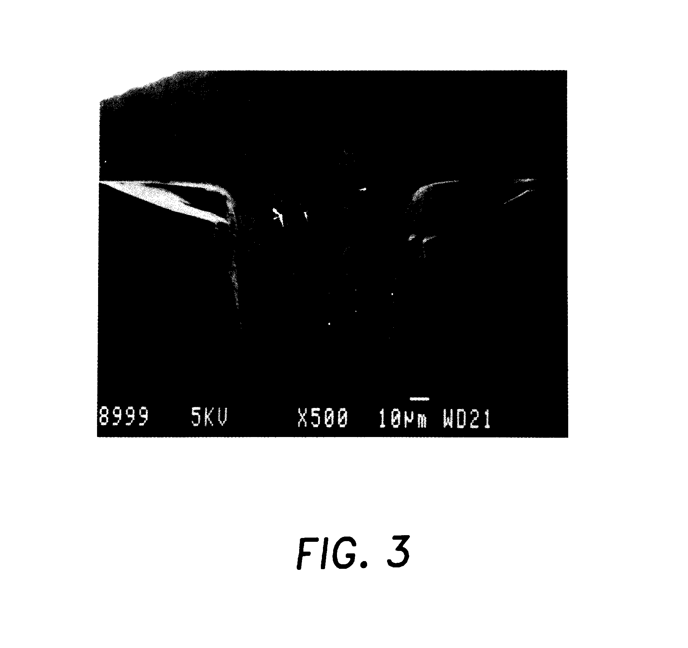

In Fig.3, the SEM is of a 100μ thick film on a silicon wafer of a photoresist made by a procedure similar to that of Example 1 but without the copolymer. Soft bake: 60°C/120 secs., 80°C/90 secs., and 90°C/90 secs. Exposure: Karl Suss, 22.8 J/cm$^2$, contact. CD: 50μ. The SEM shows residual photoresist on the substrate at the bottom of the via and it shows the effects of outgassing and cracking of the photoresist.

After development of the exposed photoresist, the substrate bearing it may be post-baked to increase the adhesion of the coating to the substrate and its resistance to plating solutions and the like.

## Claims

1. A method for the preparation of relief structures on a substrate comprising depositing on the substrate a single layer of an amount of a positive photoresist composition sufficient to form a film having a dry thickness of more than 5μm and up to 100μm, said composition comprising a novolac resin, a photosensitizer, a copolymer of an alkyl vinyl ether and an anhydride-forming unsaturated dicarboxylic acid, or an ester or the anhydride thereof, and a solvent, drying the layer, exposing the film imagewise to actinic radiation, baking the exposed film, and developing the film with an aqueous alkaline developer.

2. A method according to claim 1 wherein the amount of photoresist composition is sufficient to provide a film thickness at least 40μm.

3. A method according to claim 1 or claim 2 wherein the photosensitizer is a 2-diazo-1-naphthoquinone-5-sulfonyl ester.

4. A method according to any preceding claim wherein the amount of solvent is from 40 to 60 percent by weight.

5. A radiation sensitive recording material comprising a substrate and a one-ply positive photoresist film having a thickness of from 6μm to 100μm, said photoresist comprising a novolac resin, a photosensitizer, and a copolymer of an alkyl vinyl ether and an anhydride-forming unsaturated dicarboxylic acid or an ester or the anhydride thereof.

6. A recording material according to claim 5 wherein the film is from 20 to 50μm thick

7. A recording material according to claim 5 or claim 6 wherein the ether is methyl vinyl ether.

8. A recording material according to any one of claims 5 to 7 wherein the vinyl ether and the unsaturated acid in the copolymer are equimolar.

9. A substrate having a relief structure thereon, said structure consisting of one layer of a positive photoresist having a thickness of greater than 5μm and up to 100μm, said photoresist comprising a novolac resin, a photosensitizer, and a copolymer of an alkyl vinyl ether and an anhydride-forming unsaturated dicarboxylic acid or an ester or the anhydride thereof, said layer having one or more substantially vertical grooves extending to the substrate and having widths of from 3 to 50μm.

10. A substrate according to claim 9 wherein the aspect ratio is from 1 to 10.

**FIG. 1**

FIG. 2

8999    5KV        X500    10μm  WD21

FIG. 3

**European Patent Office**

# EUROPEAN SEARCH REPORT

Application Number

EP 93 30 6421

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | GB-A-1 243 963 (HOWSON-ALGRAPHY LTD.) 25 August 1971 * claims 1,6,13 * | 1-10 | G03F7/004 G03F7/023 |
| A | DE-A-3 736 996 (BASF AG) 11 May 1989 * claim 1 * | 1-10 | |
| A | US-A-4 728 597 (HSIEH ET AL.) 1 March 1988 * column 2, line 5-18 * | 1-10 | |
| A | US-A-4 448 875 (D.F. LEWIS) 15 May 1984 * claim 1 * | 1-10 | |
| | | | TECHNICAL FIELDS SEARCHED (Int. Cl.5) |
| | | | G03F |

The present search report has been drawn up for all claims

| Place of search | Date of completion of the search | Examiner |
|---|---|---|
| MUNICH | 21 DECEMBER 1993 | Thiele N.K. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P0401)